Europäisches Patentamt

(19) European Patent Office

Office européen des brevets

(11) **EP 0 880 229 A1**

(12) **EUROPEAN PATENT APPLICATION**

(43) Date of publication:
25.11.1998 Bulletin 1998/48

(51) Int. Cl.$^6$: **H03K 19/0175**, H03K 19/0185

(21) Application number: 98109013.7

(22) Date of filing: 18.05.1998

(84) Designated Contracting States:
AT BE CH CY DE DK ES FI FR GB GR IE IT LI LU
MC NL PT SE
Designated Extension States:
AL LT LV MK RO SI

(30) Priority: 19.05.1997 JP 128385/97

(71) Applicant:
NIPPON PRECISION CIRCUITS INC.
Tokyo (JP)

(72) Inventor: **Ueno, Naoki**
**Shiobara-cho, Nasu-gun, Tochigi-ken (JP)**

(74) Representative:
**Grünecker, Kinkeldey,**
**Stockmair & Schwanhäusser**
**Anwaltssozietät**
**Maximilianstrasse 58**
**80538 München (DE)**

(54) **Logic interface circuit**

(57)     To provide an output signal having a logic level of full swing in respect of an input signal, promote a maximum response frequency and promote low power consumption, a line on an input side of a first current mirror circuit 3 is constituted by a collector of one transistor Q1 of a differential circuit 1 receiving the input signal and a line on an input side of a second current mirror circuit 4 is constituted by a collector of other transistor Q2 and a third current mirror circuit 5 is formed on respective output sides of the first and the second current mirror circuits 3 and 4 and on a side of a potential different from the potential of the first and the second current mirror circuits 3 and 4 by which the maximum response frequency is promoted and an output of full swing can be constituted. Further, low power consumption is promoted since the invented circuit can be constituted by a smaller number of elements.

FIG. 1

EP 0 880 229 A1

## Description

### Background of the Invention

#### 1. Field of the Invention

The present invention relates to a logic interface circuit.

#### 2. Description of Related Art

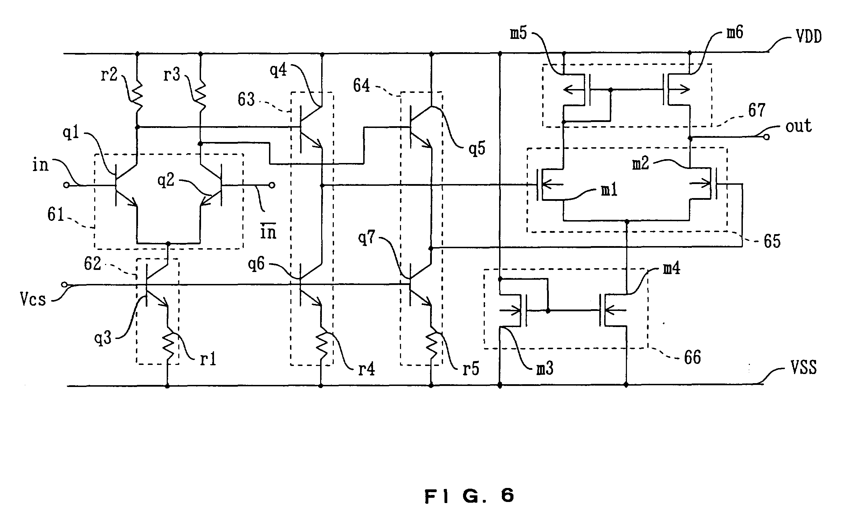

At present, a circuit having a comparatively small logic level such as an ECL (Emitter Coupled Logic) circuit, cannot be simply connected to a circuit requiring a large logic level such as a CMOS (Complementary Metal Oxide Semiconductor) circuit because of a difference in logical levels and accordingly, these two circuits are connected via a logic interface circuit as follows. For example, as shown by Fig. 6, the logic interface circuit is firstly provided with an amplifying stage which is constituted by a differential circuit 61 comprising npn bipolar transistors (hereinafter, simply referred to as transistors) q1 and q2 receiving signals of ECL levels which are inputted from input terminals "in" and "$\overline{\text{in}}$" at the respective bases and which are mutually inverted, resistors r2 and r3 connected between the collectors of the transistors q1 and q2 of the differential circuit 61 and a power source terminal VDD, and a current supply circuit 62 comprising a transistor q3 and a resistor r1 which are connected in series between the emitters of the transistors q1 and q2 and a power source terminal VSS and in which amplified outputs are generated at connection points connecting the collectors of the transistors q1 and q2 and the resistors r2 and r3. The outputs amplified by the amplifying stage are lowered to potential levels by which P-channel MOS (Metal Oxide Semiconductor) transistors of an output stage, mentioned later, can be operated, by using emitter follower circuits 63 and 64. The emitter follower circuits 63 and 64 are constituted by transistors q4 and q5 for respectively receiving the outputs from the amplifying stage and transistors q6 and q7 and respective resistors r4 and r5 as current supply circuits for these. Further, the bases of the transistors q3, q6 and q7 are commonly connected to a control terminal Vcs.

The output stage is constituted by a differential circuit 65 comprising N-channel MOS transistors m1 and m2 for receiving the outputs from the amplifying stage via the emitter follower circuits 63 and 64, a current mirror circuit 66 comprising N-channel MOS transistors m3 and m4 for supplying current to the commonly connected sources of the N-channel MOS transistors m1 and m2 for constituting the differential circuit 65, and a current mirror circuit 67 constituted by P-channel MOS transistors m5 and m6 by which either one of the drains of the N-channel MOS transistors m1 and m2 for constituting the differential circuit 65 forms an input and other thereof forms an output.

By the above-described constitution, a signal of MOS level is outputted from an output terminal "out" installed at a connection point connecting the N-channel MOS transistor m2 of the differential circuit 65 and the P-channel MOS transistor m6 of the current mirror circuit 67. Further, according to the constitution of Fig. 6, a inverted signal is outputted in respect of the signal at ECL level inputted from the input terminal "in".

According to the constitution shown by Fig. 6, the input sensitivity of the differential circuit 65 comprising the MOS transistors at the output stage is lower than the input sensitivity of the differential circuit 61 comprising the bipolar transistors at the amplifying stage and accordingly, the output amplitude of the differential circuit 61 needs to be amplified once by the resistors r2 and r3. Due to such an amplifying stage, there is a problem of narrowing the frequency band. Further, the circuit is disadvantageous in view of a number of elements and current consumption.

Further, the gates of the MOS transistors constituting the current mirror circuit 66 are at the power source voltage, that is, the gates of the N-channel MOS transistors m3 and m4 are at the potential level of the power source terminal VDD and current value supplied from the N-channel MOS transistor m4 has considerable power source voltage dependency. Therefore, the power source voltage dependency of the maximum response frequency is considerable.

### Summary of the Invention

Hence, according to the present invention, a line on an input side of a first current mirror circuit is constituted by either of two outputs of a differential circuit receiving input signals, a line on an input side of a second current mirror circuit is constituted by other thereof and a third current mirror circuit is formed on respective output sides of the first and the second current mirror circuits and on a side of a potential different from a potential of the first and the second current mirror circuits by which an amplifying stage is dispensed with, the frequency band is widened, the maximum response frequency is promoted and a full swing output can be constituted.

According to an aspect of the present invention, there is provided a logic interface circuit comprising a differential circuit comprising a first and a second active element terminals on one side of which are respectively connected to a common current supply circuit, terminals on other side of which are respectively connected to a first and a second line which are different from each other and control terminals of which respectively receive a first and a second input signal, a first current mirror circuit which includes a third active element installed on the first line and a fourth active element installed on a third line, an input side of which is constituted by the first line and an output side of which is constituted by the third line, a second current mirror circuit which includes a fifth active element installed on the second line and a sixth active element installed on a fourth line, an input side of which is constituted by the second line and an output side of which is constituted by the fourth line, a third current mirror which includes a seventh active element installed on the third line having a conductive type different from a conductive type of the fourth active element and an eighth active element installed on the fourth line having a conductive type different from a conductive type of the sixth active element, an input side of which is constituted by either of the third line and the fourth line and an output side of which is constituted by other thereof, an output terminal installed on the output side of the third current mirror and wherein an output in correspondence with either of the first input signal and the second input signal is generated from the output terminal.

It is preferable that the first and the second active elements are bipolar transistors of a first conductive type, the third through the sixth active elements are MOS transistors of a second conductive type and the seventh and the eighth active elements are MOS transistors of the first conductive type.

It is preferable that the first and the second active elements are MOS transistors of a first conductive type, the third through the sixth active elements are MOS transistors of a second conductive type and the seventh and the eighth active elements are MOS transistors of the first conductive type.

It is preferable that resistors are installed on sides of power source terminals of the third through the eighth active elements.

It is preferable that the first input signal and the second input signal are signals inverted to each other.

It is preferable that a reference potential is constituted by either of the first input signal and the second input signal.

It is preferable to constitute a logic interface circuit comprising a differential circuit comprising a first and a second npn type bipolar transistor emitters of which are respectively connected to a common current supply circuit, collectors of which are respectively connected to a first and a second line which are different from each other and bases of which respectively receive a first and a second input signal, a first current mirror circuit which includes a first P-channel MOS transistor installed on the first line and a second P-channel MOS transistor installed on a third line, an input side of which is constituted by the first line and an output side of which is constituted by the third line, a second current mirror circuit which includes a third P-channel MOS transistor installed on the second line and a fourth P-channel MOS transistor installed on a fourth line, an input side of which is constituted by the second line and an output side of which is constituted by the fourth line, a third current mirror which includes a fifth N-channel MOS transistor installed on the third line and a sixth N-channel MOS transistor installed on the fourth line, an input side of which is constituted by either of the third line and the fourth line and an output side of which is constituted by other thereof, an output terminal installed on the output side of the third current mirror, and wherein an output in correspondence with either of the first input signal and the second input signal is generated from the output terminal.

It is preferable to constitute a logic interface circuit comprising a first and a second potential line having potentials different from each other, a differential circuit comprising a first and a second active element terminals on one side of which are respectively connected to the first potential line via a common current supply circuit and control terminals of which respectively receive a first and a second input signal, a first current mirror circuit which includes a third active element connected between other terminal of the first active element and the second potential line and a fourth active element one terminal of which is connected to the second potential line, an input side of which is constituted by the third active element and an output side of which is constituted by the fourth active element, a second current mirror circuit which includes a fifth active element connected between other terminal of the second active element and the second potential line and a sixth active element one terminal of which is connected to the second potential line, an input side of which is constituted by the fifth active element and an output side of which is constituted by the sixth active element, a third current mirror circuit which includes a seventh active element connected between other terminal of the fourth active element and the first potential line having a conductive type different from a conductive type of the fourth active element and an eighth active element connected between other terminal of the sixth active element and the first potential line having a conductive type different from a conductive type of the sixth active element, an input side of which is constituted by either of the seventh active element and the eighth active element and an output side of which is constituted by other thereof, an output terminal installed on the output side of the third current mirror, and wherein an output in correspondence with either of the first input signal and the second input signal is generated from the output terminal. It is also preferable that the third through the sixth active elements are connected to the second potential line individually via resistors and the seventh and the eighth active elements are connected to the first potential line individually via resistors.

Brief Description of the Drawings

Fig. 1 is an explanatory view for explaining the constitution of a first embodiment of the present invention;

Fig. 2 is an explanatory view for explaining the constitution of a second embodiment of the present invention;

Fig. 3 is an explanatory view for explaining the constitution of a third embodiment of the present invention;

Fig. 4 is an explanatory view for explaining the constitution of a fourth embodiment of the present invention;

Fig. 5 is an explanatory view for explaining the constitution of a fifth embodiment of the present invention; and

Fig. 6 is an explanatory view for explaining a conventional technology.

Detailed Description of the Preferred Embodiment

Next, an explanation will be given of a logic interface circuit for converting a logic level of a signal from ECL level to MOS level according to an embodiment of the present invention.

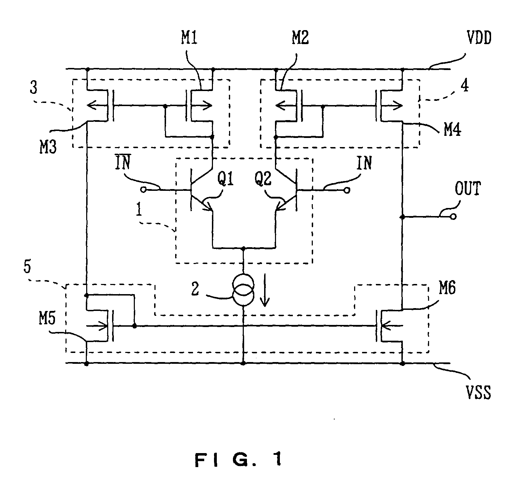

First, an explanation will be given of the constitution of this example in reference to Fig. 1. In Fig. 1, numeral 1 designates a differential circuit and numeral 2 designates a current supply circuit. The differential circuit 1 is constituted by connecting the emitters of npn bipolar transistors (hereinafter, simply referred to as transistors) Q1 and Q2 to the current supply circuit 2 and the respective bases receive input signals at ECL level which are mutually inverted. In this case, the base of the transistor Q1 constitutes an input terminal $\overline{\text{IN}}$ and the base of the transistor Q2 constitutes an input terminal IN. Although in this example, an output signal in correspondence with the input signals is outputted, when the input terminals IN and $\overline{\text{IN}}$ are switched, the circuit can also be constituted such that a signal inverted to the input signal is outputted. The current supply circuit 2 is provided with a constitution similar to that of the conventional current supply circuit 62 comprising the transistor q3 and the resistor r1 and a detailed explanation thereof by illustration will be omitted. Also, the emitters of the transistors Q1 and Q2 are connected to the power source terminal VSS via the current supply circuit 62. In this example, the power source terminal VSS is regarded as a first potential line and the power source terminal VDD, mentioned later, is regarded as a second potential line.

Numerals 3 and 4 designate respectively a first and a second current mirror circuit with the transistors Q1 and Q2 as their respective input sides. That is, the first current mirror circuit 3 is constituted by connecting the gate and the drain of a P-channel MOS transistor M1 to the collector of the transistor Q1 and connecting a connection point therebetween to the gate of a P-channel MOS transistor M3 on the output side. Similarly, the second current mirror circuit 4 is constituted by connecting the gate and the drain of a P-channel MOS transistor M2 to the collector of the transistor Q2 and connecting a connection point therebetween to the gate of a P-channel MOS transistor M4 on the output side.

Numeral 5 designates a third current mirror circuit comprising an N-channel MOS transistors M5 and M6. The drain of the N-channel MOS transistor M5 is connected to the output side of the first current mirror circuit 3, that is, the drain of the P-channel MOS transistor M3 and the drain of the N-channel MOS transistor M6 is connected to the output side of the current mirror circuit 4, that is, the drain of the P-channel MOS transistor M4. The drain and the gate of the N-channel MOS transistor M5 are connected and a connection point therebetween is connected to the gate of the N-channel MOS transistor M6, the side of the N-channel MOS transistor M5 constitutes the input side, the side of the N-channel MOS transistor M6 constitutes the output side, and an output in correspondence with the input terminal IN is generated from an output terminal OUT connected to the drain of the N-channel MOS transistor M6. Further, when the input side and the output side are switched, a constitution of generating an output signal inverted to the input signal can be formed. In this case, the sources of the P-channel MOS transistors M1, M2, M3 and M4 are connected to the second potential line of the power source terminal VDD (5V) and the sources of the N-channel MOS transistors M5 and M6 are connected to the first potential line of the power source terminal VSS (0V).

Next, an explanation will be given of the operation of this example.

Now, when the mutually inverted input signals are applied to the input terminals IN and $\overline{\text{IN}}$, differential output current in correspondence with differential input voltage in accordance with these input signals are caused at the collectors of the transistors Q1 and Q2. In this case, when the potential of the input terminal IN is on the side of "L", which means "Low level" hereinafter, and the potential of the input terminal $\overline{\text{IN}}$ is on the side of "H", which means "High level" hereinafter, collector current of the transistor Q1 is increased and collector current of the transistor Q2 is reduced by that amount. Thereby, the P-channel MOS transistor M1 on the input side of the first current mirror circuit 3 is made ON and the P-channel MOS transistor M2 on the input side of the second current mirror circuit 4 is made OFF. Incidentally, expression of "ON" or "OFF" used here designates a "larger" state or a "smaller" state when values of current flowing in the respective MOS transistors are compared and similar expression will be used in the following explanation. For example, whether the output from the output terminal OUT is at "H" or "L" is determined by a large or small relationship of values of current flowing in the P-channel MOS transistor M4 and the N-channel MOS transistor M6. When a value of current flowing in the P-channel MOS transistor M4 is at a state smaller than a value of current flowing in the N-channel MOS transistor M6, that is, when the P-channel MOS transistor M4 and the N-channel MOS transistor M6 are brought into OFF state and ON state respectively, defined here, the output is at "L". In the first current mirror circuit 3, the P-channel MOS transistor M3 on the output side is also made ON by an increase in the current value on the input side. In the second current mirror circuit 4, by a decrease in the current value on the input side, the P-channel MOS transistor M4 on the output side is also made OFF. Now, in the third current mirror circuit 5, by the drain current of the P-channel MOS transistor M3 on the output side of the first current mirror circuit 3, the N-channel MOS transistor M5 on the input side is made ON and the N-channel MOS transistor M6 on the output side is also made ON. Thereby, the potential of the output terminal OUT falls on the side of the power source terminal VSS.

Conversely, when the potential of the input terminal IN is on the side of "H" and the potential of the input terminal $\overline{\text{IN}}$ is on the side of "L", by the collector current of the transistor Q2, the P-channel MOS transistor M2 on the input side of the second current mirror circuit 4 is made ON, and the P-channel MOS transistor M1 on the input side of the first current mirror circuit 3 is made OFF. In the second current mirror circuit 4, by an increase in the current value on the input side, the P-channel MOS transistor M4 on the output side is also made ON and the potential of the output terminal OUT is drawn to the side of the power source terminal VDD. In this case, in the first current mirror circuit 3, by a decrease in the current value on the input side, the P-channel MOS transistor M3 on the output side is also made OFF and therefore, in the third current mirror circuit 5, the N-channel MOS transistor M5 on the input side is made OFF and the N-channel MOS transistor M6 on the output side is also made OFF. Thereby, the output terminal OUT is intercepted from the power source terminal VSS and the potential of the output terminal OUT rises to the side of the power source terminal VDD.

As described above, differential output current in correspondence with differential input to the transistors Q1 and Q2 produces the difference in the collector current of these and the current of difference flows in or flows out to and from the terminal OUT via the first through the third current mirror circuits whereby the potential of the output terminal OUT is changed. Thereby, the potential of the output terminal OUT can be swung fully by a voltage between the power source terminals VDD and VSS.

Incidentally, in the actual use, the output terminal OUT is connected to the gate of a MOS transistor and accordingly, a capacitive load is applied.

Further, when the potential of the output terminal OUT is equal to the potentials of the sources of the P-channel MOS transistor M4 and the N-channel MOS transistor M6, the output current is not flown. According to the first through the third current mirror circuits constituted by the MOS transistors, even in a state where the output current is not flown and current is not mirrored, it is the normal operational state.

By the above-described operation, the logic level of a signal can be converted excellently from ECL level to MOS level of full swing.

Further, an amplifying stage for amplifying ECL level is not needed to install as in the conventional circuit and high speed operation can be carried out. That is, the output from the differential circuit 1 is complementarily amplified by the first through the third current mirror circuits and accordingly, the above-described amplifying stage is not needed and high speed operation can be carried out. That is, the band of the response frequency can be promoted.

Further, the gate voltage of the N-channel MOS transistor constituting the third current mirror circuit 5 is controlled by the value of current flowing in the first current mirror circuit 3 and accordingly, the power source voltage dependency is inconsiderable. Thereby, the power source voltage dependency of the maximum response frequency can be made inconsiderable which also contributes to promotion of the response frequency. Further, one portion of the differential output current of the differential circuit 1 is not abandoned and both portions thereof are effectively used and accordingly, promotion of the input sensitivity can be expected.

By dispensing with the above-described amplifying stage, a number of elements can be reduced and the power consumption can be reduced.

According to the above-described constitution, the logic interface circuit is constituted between the power source terminals VDD and VSS and the voltage between the power source terminals VDD and VSS are made to swing fully as the logic level. However, the logic interface circuit may be installed not only between the power source terminals but also between terminals of signals at various voltages and various voltages can be swung fully as logic levels.

Further, according to the above-described constitution, the mutually inverted input signals are applied to the differential circuit 1 as inputs. However, other input may be fixed to a reference potential. In that case, collector currents in correspondence with potential difference between potentials of input signals and the reference potential are flown in the transistors Q1 and Q2 by which the P-channel MOS transistors M1 and M2 are respectively driven. That is, when, for example, the input terminal $\overline{\text{IN}}$ is set to a fixed potential, in the case where the potential of an input signal from the input terminal IN is higher than the fixed potential, larger collector current is flown by the transistor Q1 by that amount, the P-channel MOS transistors M1 and M2 are respectively made ON and OFF. Conversely, when the potential of the input signal is lower than the fixed potential, large collector current is flown in the transistor Q2 by that amount and the P-channel MOS transistors M1 and M2 are respectively made OFF and ON. Other operation is similar to that described above.

According to the above-described constitution, sizes (gate width W / gate length L) of the P-channel MOS transistors M1 and M2 and the P-channel MOS transistors M3 and M4 may be equal to each other. However, the sizes are not limited thereto. When sizes of the P-channel MOS transistors M3 and M4 are made larger than sizes of the P-channel MOS transistors M1 and M2, the drive capability can be promoted while the current supply function of the current supply circuit 2 is made to stay as it is.

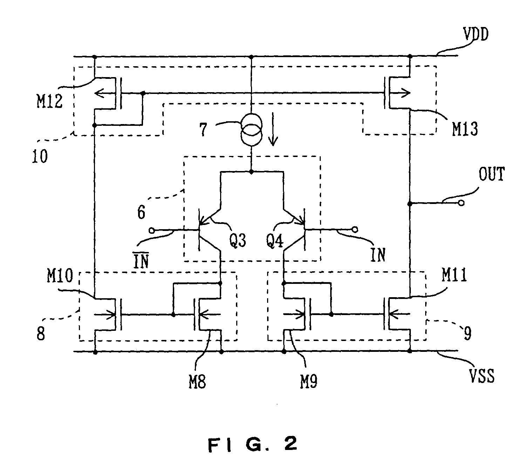

Further, according to the above-described embodiment, the differential circuit 1 is constituted by the npn bipolar transistors, the first and the second current mirror circuits are constituted by the P-channel MOS transistors and the third current mirror circuit is constituted by the N-channel MOS transistors. However, the conductive types of the respective transistors may be changed and in that case, the polarities are reversed as shown by Fig. 2. Further, notations in Fig. 2 the same as those in Fig. 1 designate the same constituent elements and stay the same also in the following figures.

In Fig. 2, numeral 6 designates a differential circuit, numeral 7 designates a current supply circuit and numerals 8 through 10 designate respectively a first through a third current mirror circuit. Further, notations Q3 and Q4 designate pnp bipolar transistors, notations M8 through M11 designate N-channel MOS transistors and numerals M12 and M13 designate P-channel MOS transistors. Further, although no particular explanation will be given of the operation of the second embodiment shown by Fig. 2, the operation is substantially similar to that of the first embodiment and similar operation and effect is resulted. Further, the same goes with embodiments shown in the following views.

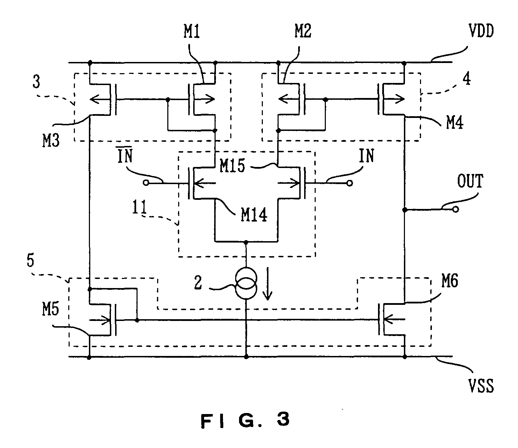

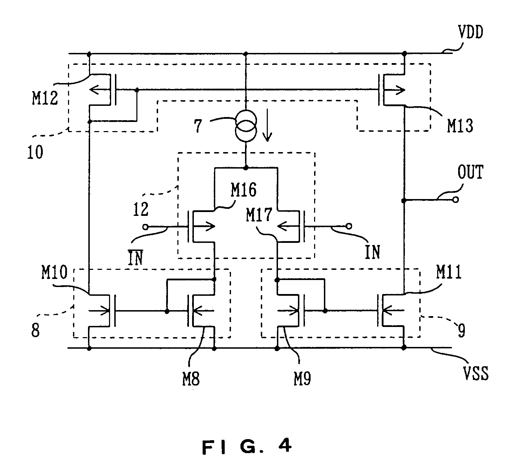

Although in the constitutions shown by Fig. 1 and Fig. 2, the differential circuits 1 and 6 are constituted by the bipolar transistors, they may be constituted by MOS transistors and can be constituted respectively as shown by Fig. 3 and Fig. 4. In these figures, numerals 11 and 12 designate differential circuits, notations M14 and M15 designate N-channel MOS transistors and notations M16 and M17 designate P-channel MOS transistors.

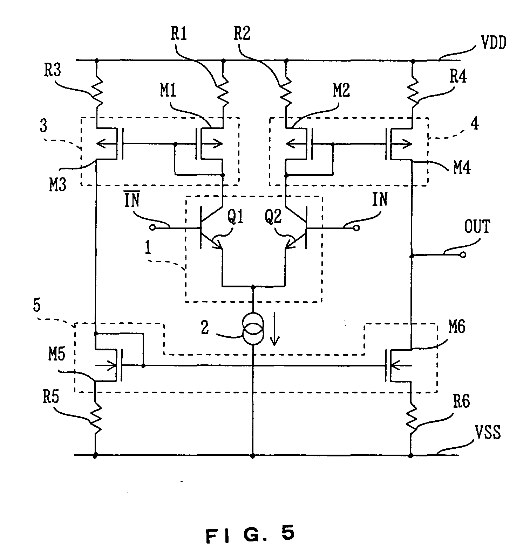

Further, in the constitutions shown by the above-described respective views, the sources of the respective MOS transistors are connected directly to the power source terminals. However, the constitutions are not limited thereto but the sources of the respective MOS transistors may be connected to the power source terminals via resistors. For example, the constitution of Fig. 1 is changed to a constitution shown by Fig. 5. In Fig. 5, notations R1, R2, R3, R4, R5 and R6 designate resistors.

Although in the respective embodiments described above, conversion is carried out from ECL level to MOS level, the present invention is not limited thereto but is applicable to constitutions where conversion is carried out between various signal levels.

According to the present invention, an amplifying stage as in the conventional case is not needed to install, high speed operation can be carried out, the power source voltage dependency of the response frequency can be reduced and the maximum response frequency can be promoted. Further, an output signal having a logic level of full swing can be provided. Also, an effect of capable of reducing a delay value can also be achieved by dispensing with the amplifying stage described above. Further, a portion of the differential output current of the differential circuit is not abandoned but both portions thereof are used effectively and therefore, promotion of the input sensitivity can be expected. Further, a number of elements can be reduced and low power consumption can be promoted.

As described above, according to the present invention, the function can be promoted compared with the conventional technology, simplification of structure can be promoted and economic effect can be enhanced.

**Claims**

1. A logic interface circuit comprising:

   a differential circuit comprising a first and a second active element terminals on one side of which are respectively connected to a common current supply circuit, terminals on other side of which are respectively connected to a first and a second line which are different from each other and control terminals of which respectively receive a first and a second input signal;

   a first current mirror circuit which includes a third active element installed on the first line and a fourth active element installed on a third line, an input side of which is constituted by the first line and an output side of which is constituted by the third line;

   a second current mirror circuit which includes a fifth active element installed on the second line and a sixth active element installed on a fourth line, an input side of which is constituted by the second line and an output side of which is constituted by the fourth line;

   a third current mirror which includes a seventh active element installed on the third line having a conductive type different from a conductive type of the fourth active element and an eighth active element installed on the fourth line having a conductive type different from a conductive type of the sixth active element, an input side of which is constituted by either of the third line and the fourth line and an output side of which is constituted by other thereof;

an output terminal installed on the output side of the third current mirror; and

wherein an output in correspondence with either of the first input signal and the second input signal is generated from the output terminal.

2. The logic interface circuit according to Claim 1: wherein the first and the second active elements are bipolar transistors of a first conductive type, the third through the sixth active elements are MOS transistors of a second conductive type and the seventh and the eighth active elements are MOS transistors of the first conductive type.

3. The logic interface circuit according to Claim 1: wherein the first and the second active elements are MOS transistors of a first conductive type, the third through the sixth active elements are MOS transistors of a second conductive type and the seventh and the eighth active elements are MOS transistors of the first conductive type.

4. The logic interface circuit according to Claim 1: wherein resistors are installed on sides of power source terminals of the third through the eighth active elements.

5. The logic interface circuit according to Claim 1: wherein the first input signal and the second input signal are signals inverted to each other.

6. The logic interface circuit according to Claim 1: wherein a reference potential is constituted by either of the first input signal and the second input signal.

7. A logic interface circuit comprising:

a differential circuit comprising a first and a second npn type bipolar transistor emitters of which are respectively connected to a common current supply circuit, collectors of which are respectively connected to a first and a second line which are different from each other and bases of which respectively receive a first and a second input signal;

a first current mirror circuit which includes a first P-channel MOS transistor installed on the first line and a second P-channel MOS transistor installed on a third line, an input side of which is constituted by the first line and an output side of which is constituted by the third line;

a second current mirror circuit which includes a third P-channel MOS transistor installed on the second line and a fourth P-channel MOS transistor installed on a fourth line, an input side of which is constituted by the second line and an output side of which is constituted by the fourth line;

a third current mirror which includes a fifth N-channel MOS transistor installed on the third line and a sixth N-channel MOS transistor installed on the fourth line, an input side of which is constituted by either of the third line and the fourth line and an output side of which is constituted by other thereof;

an output terminal installed on the output side of the third current mirror; and

wherein an output in correspondence with either of the first input signal and the second input signal is generated from the output terminal.

8. A logic interface circuit comprising:

a first and a second potential line having potentials different from each other;

a differential circuit comprising a first and a second active element terminals on one side of which are respectively connected to the first potential line via a common current supply circuit and control terminals of which respectively receive a first and a second input signal;

a first current mirror circuit which includes a third active element connected between other terminal of the first active element and the second potential line and a fourth active element one terminal of which is connected to the second potential line, an input side of which is constituted by the third active element and an output side of which is constituted by the fourth active element;

a second current mirror circuit which includes a fifth active element connected between other terminal of the second active element and the second potential line and a sixth active element one terminal of which is connected to the second potential line, an input side of which is constituted by the fifth active element and an output side of which is constituted by the sixth active element;

a third current mirror circuit which includes a seventh active element connected between other terminal of the fourth active element and the first potential line having a conductive type different from a conductive type of the fourth active element and an eighth active element connected between other terminal of the sixth active element and the first potential line having a conductive type different from a conductive type of the sixth active element, an input side of which is constituted by either of the seventh active element and the eighth active element and an output side of which is constituted by other thereof;

an output terminal installed on the output side of the third current mirror; and

        wherein an output in correspondence with either of the first input signal and the second input signal is generated from the output terminal.

9. The logic interface circuit according to Claim 8:
        wherein the third through the sixth active elements are connected to the second potential line individually via resistors and the seventh and the eighth active elements are connected to the first potential line individually via resistors.

FIG. 1

F I G. 2

F I G. 3

F I G. 4

F I G. 5

F I G. 6

EP 0 880 229 A1

## EUROPEAN SEARCH REPORT

European Patent Office

Application Number

EP 98 10 9013

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 231 062 A (TOKYO SHIBAURA ELECTRIC CO) 5 August 1987 * figures 1,2 * | 1,2,5,7,8 | H03K19/0175 H03K19/0185 |
| X | US 4 841 175 A (DE MAN ERIK ET AL) 20 June 1989 * column 4, line 39 - column 6, line 2; figure 3 * | 1,3,5,6,8 | |
| X | US 5 332 935 A (SHYU JYN-BANG) 26 July 1994 * column 4, line 33 - line 42; figures 1,2 * | 1,3,5,8 | |

TECHNICAL FIELDS SEARCHED (Int.Cl.6)

H03K

The present search report has been drawn up for all claims

| Place of search | Date of completion of the search | Examiner |
|---|---|---|
| THE HAGUE | 30 July 1998 | Feuer, F |